(19) Europäisches Patentamt / European Patent Office / Office européen des brevets

(11) **EP 1 931 030 B1**

## (12) FASCICULE DE BREVET EUROPEEN

(45) Date de publication et mention
de la délivrance du brevet:
**02.09.2009 Bulletin 2009/36**

(51) Int Cl.:
*H03K 5/02* *(2006.01)* *G01R 19/00* *(2006.01)*

(21) Numéro de dépôt: **07122105.5**

(22) Date de dépôt: **03.12.2007**

(54) **Préamplificateur de courant et comparateur de courant associé**

Stromvorverstärker und damit verbundener Stromvergleicher

Current preamplifier and associated current comparator

(84) Etats contractants désignés:
**DE FR GB IT**

(30) Priorité: **07.12.2006 FR 0655366**

(43) Date de publication de la demande:
**11.06.2008 Bulletin 2008/24**

(73) Titulaire: **COMMISSARIAT A L'ENERGIE
ATOMIQUE
75015 Paris (FR)**

(72) Inventeur: **Tchagaspanian, Michael
38330 Saint Ismier (FR)**

(74) Mandataire: **Poulin, Gérard et al
Brevalex
3, rue du Docteur Lancereaux
75008 Paris (FR)**

(56) Documents cités:
**JP-A- 10 284 955** **JP-A- 2002 335 133**

• **MIN BYUNG-MOO ET AL: "High performance CMOS current comparator using resistive feedback network" 29 octobre 1998 (1998-10-29), ELECTRONICS LETTERS, IEE STEVENAGE, GB, PAGE(S) 2074-2076 , XP006010488 ISSN: 0013-5194 * le document en entier ***

## Description

Domaine technique et art antérieur

L'invention concerne un préamplificateur de courant ainsi qu'un comparateur de courant qui comprend un préamplificateur de courant. La présente invention concerne plus particulièrement un préamplificateur d'un courant de type impulsionnel c'est-à-dire un courant présentant des variations hautes fréquences.

Le comparateur de courant de l'invention est un comparateur de courant rapide et de faible consommation.

Le comparateur de courant de l'invention s'applique dans tout domaine où il est important d'avoir des temps de réponse de circuit très courts et où une faible consommation des circuits est souhaitée. A titre d'exemple non limitatif, l'invention sera plus particulièrement décrite dans le domaine de l'imagerie, domaine dans lequel des images en relief sont formées à partir de signaux délivrés par des matrices de pixels détecteurs.

Des performances de comparateurs de courant rapides de l'art connu sont données dans le tableau ci-dessous :

| Comparateur | Stimuli en entrée 10nA | | Stimuli en entrée 100nA | |
|---|---|---|---|---|
| | Temps de réponse | Consommation | Temps de réponse | Consommation |
| [1] | 13ns | 560$\mu$W | 8ns | 400$\mu$W |
| [2] | 500ns | 130$\mu$W | 80ns | 120$\mu$W |
| [3] | 21ns | 575$\mu$W | 10ns | 460$\mu$W |
| [4] | 14ns | 580$\mu$W | 9ns | 560$\mu$W |

Le comparateur [1] est divulgué dans le document "A high speed/power ratio continuous-time CMOS current comparator", Lu Chen, Bingxue Shi et Chun Lu, IEEE 2000, pp 883-886.

Le comparateur [2] est divulgué dans le document "Novel approach to high speed CMOS current comparator", Traff H, Electron. Lett. 1992, 28, (3), pp. 310-312.

Le comparateur [3] est divulgué dans le document "High performance CMOS current comparator", Tang, ATK, and Toumazou C, Electron. Lett, 1994, 30, (1), pp. 5-6.

Le comparateur [4] est divulgué dans le document "High performance CMOS current comparator using resistive feedback network", B.M. Min and S. W. Kim, Electron. Lett, vol.34, No22, pp.2074-2076, 1998.

L'ensemble des comparateurs [1], [2], [3], [4] repose sur le principe d'un inverseur CMOS contre réactionné par un circuit électronique permettant de polariser l'inverseur dans un équilibre parfait autour du point de basculement.

Ces comparateurs donnent des performances très variables en rapidité en fonction du positionnement et du dimensionnement des polarisations statiques. En effet, pour atteindre de bonne performance en rapidité, ils nécessitent l'usage d'une forte consommation statique, par exemple plus de 500$\mu$W pour passer sous le seuil des 20ns de temps de réponse pour une impulsion en entrée de +/-10nA (voir tableau ci-dessus).

Ceci représente un inconvénient. Les architectures traditionnelles ne donnent donc pas satisfaction. Leurs limites sont atteintes.

Exposé de l'invention

L'invention ne présente pas les inconvénients ci-dessus.

La présente invention prévoit un préamplificateur de courant ayant une entrée apte à recevoir ou fournir un courant d'entrée présentant au moins une impulsion, le préamplificateur comprenant un étage cascode régulé comprenant un transistor d'entrée et un premier générateur de courant en série aux bornes d'une alimentation, ainsi qu'un transistor de sortie et un second générateur de courant en série aux bornes de ladite alimentation, le premier noeud intermédiaire entre le premier générateur de courant et le transistor d'entrée constituant ladite entrée et étant relié à la borne de commande du transistor de sortie, le second noeud intermédiaire entre le second générateur de courant et le transistor de sortie étant relié à la borne de commande du transistor d'entrée, le préamplificateur comprenant en outre :

- des moyens de détection aptes à détecter une impulsion du courant d'entrée,
- des premiers moyens de rétroaction aptes à augmenter le courant délivré par le premier générateur de courant pendant toute la durée de détection de l'impulsion du courant d'entrée, et/ou
- des seconds moyens de rétroaction aptes à augmenter le courant délivré par le second générateur de courant pendant toute la durée de détection d'une impulsion du courant d'entrée.

Selon un mode de réalisation du préamplificateur de courant susmentionné, les moyens de détection aptes à détecter une impulsion du courant d'entrée comprennent un transistor de détection monté en diode et placé entre ledit transistor d'entrée et une borne de ladite alimentation.

Selon un mode de réalisation du préamplificateur de courant susmentionné, le premier générateur de courant comprend des premier et deuxième transistors montés en miroir de courant, le premier transistor étant placé entre l'entrée du préamplificateur et une borne de ladite alimentation, le deuxième transistor étant monté en diode et étant traversé par un courant de polarisation prédéfini.

Selon un mode de réalisation du préamplificateur de courant susmentionné, les premiers moyens de rétroaction comprennent :

- un troisième transistor relié au transistor de détection à la forme d'un miroir de courant, la borne de commande du troisième transistor étant reliée à la borne de commande du transistor de détection,
- un quatrième transistor monté en diode placé en série avec le troisième transistor aux bornes de ladite alimentation,
- un premier condensateur placé entre les bornes de commande des premier et quatrième transistors, et
- une première résistance placée entre les bornes de commande des premier et deuxième transistors.

Selon un autre mode de réalisation du préamplificateur de courant susmentionné, le second générateur de courant comprend des cinquième et sixième transistors montés en miroir de courant, le cinquième transistor étant placé entre ledit second noeud intermédiaire et une borne de ladite alimentation, le sixième transistor étant monté en diode et étant traversé par un courant de polarisation prédéfini.

Selon un autre mode de réalisation du préamplificateur de courant susmentionné, les seconds moyens de rétroaction comprennent :

- un deuxième condensateur placé entre les bornes de commande du transistor de détection et du cinquième transistor, et
- une deuxième résistance placée entre les bornes de commande des cinquième et sixième transistors.

La présente invention prévoit en outre un comparateur de courant comprenant un préamplificateur de courant et un convertisseur courant/tension en série avec le préamplificateur de courant, le préamplificateur de courant étant réalisé selon un des modes de réalisation susmentionnés.

Selon un mode de réalisation du comparateur, le convertisseur courant/tension comprend des premier et second transistors supplémentaires de type différents montés en série aux bornes de ladite alimentation, les transistors supplémentaires étant reliés en un noeud de sortie du convertisseur courant/tension, un condensateur reliant les bornes de commande des transistors supplémentaires, les bornes de commande du transistor de détection et du premier transistor supplémentaire étant reliées l'une à l'autre, une résistance étant placée entre les bornes de commande dudit deuxième transistor et du second transistor supplémentaire.

Selon une variante de réalisation, le comparateur de courant susmentionné comprend un comparateur de tension en série avec le convertisseur tension/courant.

Selon un mode de réalisation du comparateur de courant susmentionné, le comparateur de tension comprend :

- un premier transistor d'un premier type en série avec une première source de courant aux bornes d'une alimentation, le noeud intermédiaire entre le premier transistor et la première source de courant constituant la sortie du comparateur de tension,
- un deuxième transistor d'un second type placé entre une borne de ladite alimentation et la borne de commande du premier transistor, la borne de commande du deuxième transistor étant reliée à ladite sortie du comparateur de tension,
- un troisième transistor du premier type monté en diode, le troisième transistor étant en série avec une source de courant aux bornes de ladite alimentation,
- une résistance placée entre les bornes de commande des premier et troisième transistors, et
- un condensateur placé entre la borne de commande du premier transistor et l'entrée du comparateur de tension, et

dans lequel l'entrée du comparateur de tension est reliée au noeud de sortie du convertisseur courant/tension.

La présente invention prévoit en outre un circuit d'intégration photonique comprenant un comparateur de courant tel que ceux décrits ci-dessus.

L'invention concerne également un circuit d'intégration photonique comprenant un comparateur de courant selon l'invention.

Une des applications du circuit de l'invention est l'imagerie en relief. Une source de lumière éclaire un objet et à l'aide d'une matrice de pixels détecteurs, on mesure le temps de vol des photons réfléchis par l'objet. Grâce à cette mesure on peut reconstruire le relief de l'objet. La difficulté réside donc dans la rapidité de la mesure. Le comparateur de courant de l'invention répond avantageusement à cette exigence de rapidité. De plus, le comparateur de l'invention consomme très peu de courant, ce qui est particulièrement avantageux est puisqu'il est embarqué dans chaque pixel de l'imageur.

Brève description des figures

D'autres caractéristiques et avantages de l'invention apparaîtront à la lecture d'un mode de réalisation préférentiel de l'invention fait en référence aux figures jointes parmi lesquelles :

-    la figure 1 représente un schéma de principe de circuit d'intégration photonique d'un système imageur ;

-    la figure 2 représente un schéma de principe de comparateur de courant rapide selon l'invention ;

-    la figure 3 représente un circuit électronique de base qui participe au comparateur de courant de l'invention ;

-    la figure 4 représente un premier exemple d'un premier circuit électronique qui participe au comparateur de courant de l'invention ;

-    la figure 5 représente un deuxième exemple du premier circuit électronique qui participe au comparateur de courant de l'invention ;

-    la figure 6 représente un exemple d'un deuxième circuit électronique qui participe au comparateur de courant de l'invention ;

-    la figure 7 représente un premier exemple d'un troisième circuit électronique qui participe au comparateur de courant de l'invention ;

-    la figure 8 représente un deuxième exemple du troisième circuit électronique qui participe au comparateur de courant de l'invention.

Sur toutes les figures, les mêmes références désignent les mêmes éléments.

Description détaillée de mode de mise en oeuvre de l'invention

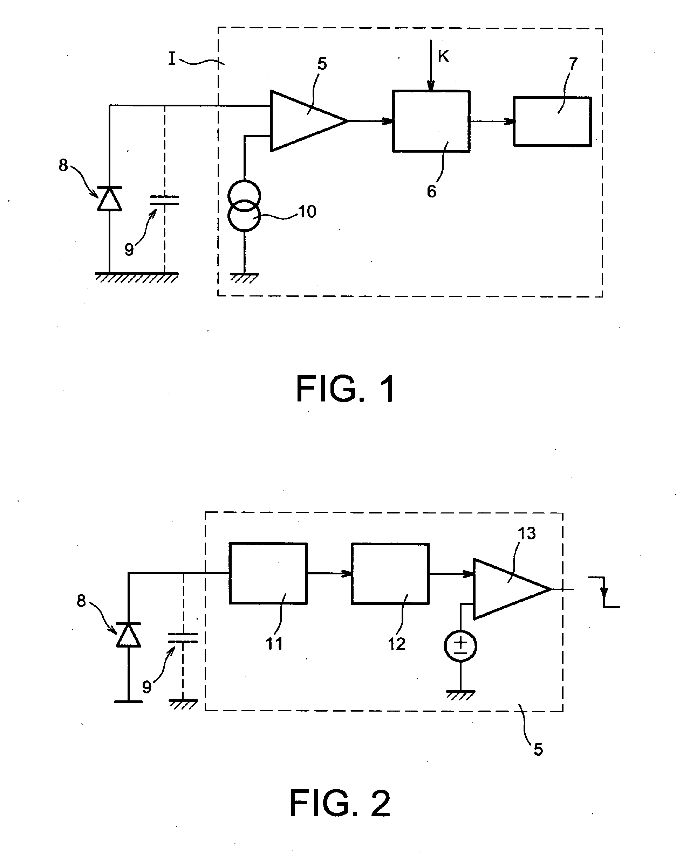

La figure 1 représente un schéma de principe de circuit d'intégration photonique d'un système imageur. Le circuit d'intégration photonique I comprend un comparateur de courant 5, un compteur numérique 6 et une mémoire 7. Une première entrée du comparateur de courant 5 est reliée à une photodiode détectrice 8 et une deuxième entrée est reliée à une source courant de référence 10 de valeur très faible par rapport aux valeurs de courant pouvant traverser la photodiode après détection d'un photon. La photodiode 8 présente une capacité parasite qui est représentée, de façon symbolique, par un condensateur 9 dessiné en pointillés.
Le circuit d'intégration photonique I date le courant délivré par la photodiode 8 en échantillonnant le compteur numérique 6 à l'aide du signal délivré par le comparateur de courant 5. Le compteur numérique 6 est au départ mis à zéro à l'aide d'une commande extérieure K. Le comptage commence. A l'arrivée des photons, le courant photonique issue de la photodiode 8 engendre une commutation du comparateur de courant 5. Celui-ci délivre alors un signal qui arrête le comptage et la valeur numérique délivrée par le compteur est mise en mémoire dans la mémoire 7.
Les valeurs numériques associées aux différents pixels détecteurs sont ensuite comparées et on en déduit le relief de l'objet imagé.
Le courant photonique peut être extrêmement faible. Or, la capacité parasite de la photodiode 8 a une valeur relativement élevée. Une partie du courant délivré par la photodiode 8 circule alors dans le condensateur parasite 9. Pour que le courant délivré par la photodiode 8 soit restitué au mieux au comparateur, ce dernier doit alors présenter une impédance de faible valeur.
Par ailleurs, deux pixels voisins peuvent recevoir simultanément des flux de photons ayant des différences de niveaux importantes dues, non pas à la profondeur du relief de l'objet imagé, mais à une différence de réflectivité de deux points voisins de l'objet. Il est alors souhaitable que le comparateur de courant ne donne pas une information erronée malgré cette différence de flux. Afin de réduire l'erreur de mesure, le mieux est alors que le comparateur de courant se déclenche le plus rapidement possible.
La figure 2 représente un schéma de principe de comparateur de courant. De fait, ce schéma de principe concerne aussi bien un comparateur de courant de l'art antérieur qu'un comparateur de courant de l'invention. Le comparateur de courant comprend plusieurs circuits élémentaires montés en série, à savoir un préamplificateur de courant 11, un convertisseur courant/tension 12 et un comparateur de tension 13. Comme cela apparaîtra dans la suite de la description, l'invention concerne chacun des circuits élémentaires qui participent au comparateur de courant.

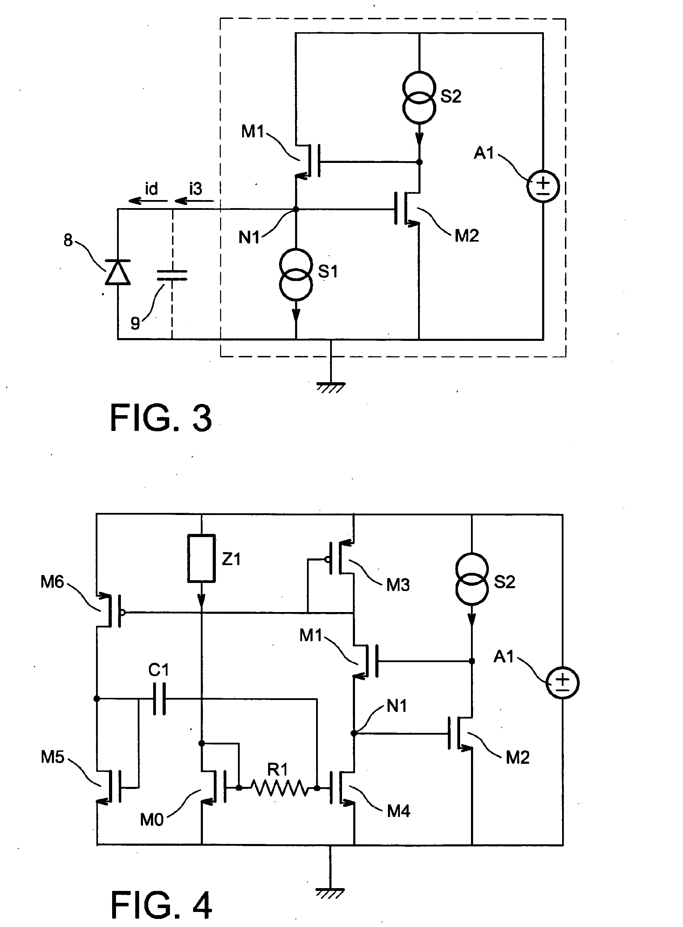

La figure 3 représente un circuit électronique de base qui participe au préamplificateur de courant de l'invention.

Le circuit électronique de base de la figure 3 est un circuit connu en soi sous le nom «d'étage cascode régulé ». Selon le mode de réalisation préférentiel de l'invention, l'étage cascode régulé est réalisé en technologie CMOS. L'étage cascode régulé comprend un transistor d'entrée M1 (transistor MOS de type N), un premier générateur de courant S1 délivrant un courant I1, un transistor de sortie M2 (transistor MOS de type N), un deuxième générateur de courant S2 délivrant un courant 12 et une alimentation A1. Le transistor d'entrée M1 et le premier générateur de courant S1 sont montés en série aux bornes de l'alimentation A1, le drain du transistor M1 étant relié à la borne positive de l'alimentation A1. Le deuxième générateur de courant S2 et le transistor de sortie M2 sont montés en série aux bornes de l'alimentation A1, la source du transistor M2 étant reliée à la borne négative de l'alimentation A1 correspondant, dans cet exemple, à la masse. La grille du transistor M1 est reliée au drain du transistor M2 et la source du transistor M1 constitue le noeud d'entrée N1 du préamplificateur de courant et, partant, du comparateur de courant. Le noeud N1 est relié à la photodiode. Dans cet exemple, la photodiode est placée entre le noeud N1 et la masse, l'anode de la photodiode étant du côté de la masse.

Un tel circuit peut présenter une impédance d'entrée de valeur très basse et c'est à ce titre qu'il répond à une des exigences de l'invention mentionnée ci-dessus.

Comme cela a déjà été mentionné précédemment, il existe un effet de concurrence entre l'impédance parasite de la photodiode due à la présence du condensateur parasite 9 (par exemple un condensateur de 100fF) et l'impédance du comparateur, c'est-à-dire l'impédance d'entrée de l'étage cascode régulé.

Le courant d'impulsion id qui circule dans la photodiode 8 est instantanément issu du condensateur parasite 9 qui se décharge légèrement. La recharge du condensateur parasite 9 s'effectue ensuite progressivement, au moyen d'un courant i3 fourni par l'étage cascode régulé. En conséquence, au plus l'impédance d'entrée de l'étage cascode régulé est faible devant l'impédance parasite du condensateur 9, au plus le courant i3 croît rapidement. Le courant i3 est l'image différée du courant id.

L'impédance d'entrée du montage cascode régulé est contrôlée par le gain dynamique des transistors M1 et M2 qui le constituent et, partant, par les courants de polarisation I1 et I2 qui parcourent les transistors respectifs M1 et M2. Il vient en effet :

$$1/Z_{in} = gds_1 \left[ 1 + \frac{gm_1}{gds_1} \left( 1 + \frac{gm_2}{gds_2} \right) \right] \quad \text{où}$$

- $Z_{in}$ est l'impédance d'entrée du montage cascode,

- $gds_1$ et $gds_2$ sont, respectivement, les conductances de sortie des transistors d'entrée et de sortie, et

- $gm_1$ et $gm_2$ sont, respectivement, les gains en courant des transistors d'entrée et de sortie.

Après simplification de la formule indiquée ci-dessus, on s'aperçoit que 1/Zi est sensiblement proportionnel à gm1, gm1 étant proportionnel à racine carrée de I1.

Pour que l'impédance $Z_{in}$ soit faible, le courant de polarisation I1 doit donc être élevé. Le courant I1 doit cependant être limité du fait de contraintes de consommation. De façon avantageuse, le préamplificateur de courant de l'invention comprend des moyens aptes à accroître le courant de polarisation I1 d'une valeur de courant proportionnelle au courant d'entrée i3 du préamplificateur. Ainsi le courant de polarisation I1 du transistor M1 est-il faible lorsque aucune détection n'est effectuée et s'accroît-il dynamiquement dès lors que survient une impulsion en courant. Une « surconsommation » du courant de polarisation I1 n'intervient alors qu'aux seuls moments utiles, c'est à dire quand il y a besoin « d'écouter » le signal d'entrée. En dehors de ces moments là, la consommation peut être très faible, car il n'y a pas de détection.

La figure 4 représente un premier exemple de préamplificateur de courant de l'invention. Dans cet exemple, le premier générateur de courant S1 est réalisé au moyen d'un miroir de courant. Par ailleurs, d'autres éléments sont ajoutés aux éléments représentés sur la figure 3 afin de réaliser des moyens de détection d'un appel de courant i3 et des moyens de modification du courant de polarisation I1 délivré par le premier générateur de courant S1. Ainsi, le préamplificateur de courant représenté en figure 4 comprend-t-il deux transistors CMOS de type P M3 et M6, trois transistors CMOS de type N M0, M4 et M5, une résistance R1 et un condensateur C1 et une charge Z1. Les transistors M0, M3 et M5 sont montés en diodes.

Le transistor M4 est placé entre le noeud N1 et la masse. La charge Z1 et le transistor M0 sont placés en série aux bornes de l'alimentation A1. Le transistor M0 est monté en diode, sa source étant reliée à la masse. Par ailleurs, le transistor M3, monté en diode, est placé entre le drain du transistor M1 et la borne positive de l'alimentation A1. Les transistors M6 et M5 sont placés en série aux bornes de l'alimentation A1, les transistors étant reliés par leurs drains et le transistor M5 étant monté en diode. Les grilles des transistors M3 et M6 sont connectées l'une à l'autre. Par ailleurs, le condensateur C1 est placé entre les grilles des transistors M4 et M5.

Dans la suite de la présente description, on entend par courant statique, le courant traversant un transistor en dehors de tout appel de courant sur l'entrée N1 du préamplificateur (i3 = 0) et on entend par courant dynamique, la variation de courant, à la hausse ou à la baisse, du courant traversant un transistor pendant les phases de fonctionnement où un courant i3 est délivré en entrée du préamplificateur.

Le premier générateur de courant S1 est réalisé par le miroir de courant incluant les transistors M0 et M4. Le choix de la charge Z1 permet de définir le courant traversant le transistor M0. La résistance R1 est placée entre les grilles des transistors M0 et M4 de façon que les transistors M0 et M4 ne constituent un miroir de courant que pour le courant statique. Le courant statique qui parcourt le transistor M4 recopie ainsi le courant statique qui parcourt le transistor M0. Autrement dit, le courant traversant le transistor M0 correspond à la valeur statique du courant I1 traversant le transistor M4 en dehors de tout appel de courant sur l'entrée N1 du préamplificateur.

Les transistors M3 et M6 constituent également un miroir de courant. De plus, le courant parcourant le transistor M5 est sensiblement égal au courant traversant le transistor M6. Les transistors M3, M6, et M5 par extension, constituent un miroir de courant pour les courants statique et dynamique. Les courants statique et dynamique qui parcourent le transistor M6 ou le transistor M5 recopient ainsi les courants statique et dynamique qui parcourent le transistor M3. On notera que le courant traversant le transistor M1 est identique à celui parcourant le transistor M3.

Par ailleurs, la capacité C1 relie les grilles des transistors M5 et M4 de façon que les transistors M5 et M4 constituent un miroir de courant uniquement pour les courants dynamiques. Le courant dynamique qui parcourt le transistor M4 recopie ainsi le courant dynamique qui parcourt le transistor M5.

A l'aide de ce montage, l'étage cascode régulé comprend une boucle d'amplification de type avalanche qui injecte un courant dynamique proportionnel au courant i3 dans le courant de polarisation I1 du transistor M4. Plus le courant d'appel i3 croît, plus l'impédance d'entrée baisse et plus le courant d'entrée croît rapidement. De façon connue en soi, le coefficient de proportionnalité entre le courant dynamique qui reproduit le courant i3 et le courant i3 est en rapport avec la géométrie des transistors qui constituent les différents miroirs de courant. Dans le cadre de l'invention, le coefficient de proportionnalité est préférentiellement choisi supérieur à 1.

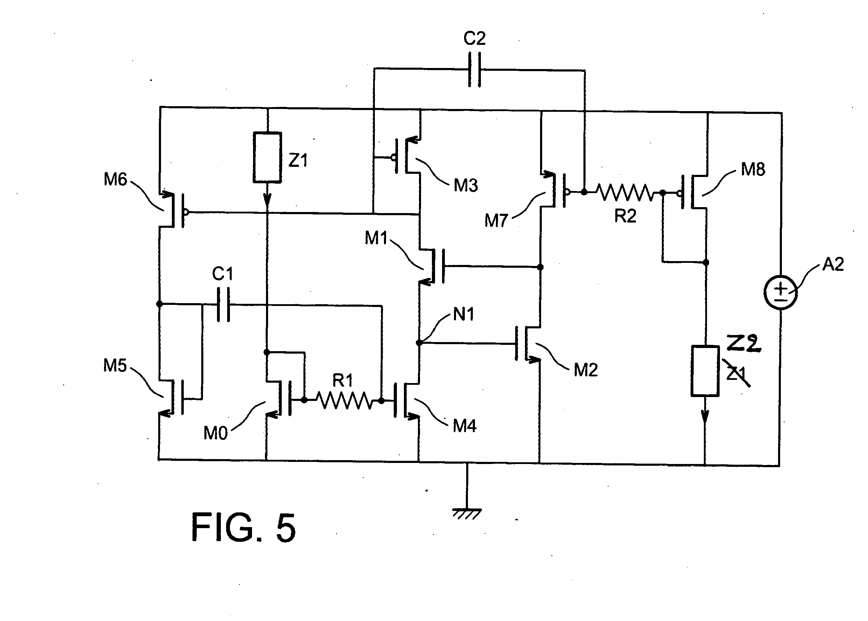

De la même manière, il est avantageux d'augmenter dynamiquement le courant de polarisation du transistor M2, afin d'accroître la rapidité du comparateur. La figure 5 représente un préamplificateur de courant qui réalise, en plus de l'augmentation dynamique du courant I1, l'augmentation dynamique du courant 12.

Dans cet exemple, le second générateur de courant S2 est réalisé au moyen d'un miroir de courant. Par ailleurs, d'autres éléments sont ajoutés aux éléments représentés sur la figure 4, afin de réaliser des moyens de modification du courant de polarisation 12 délivré par le second générateur de courant S2. Ainsi, le préamplificateur représenté en figure 5 comprend-t-il en outre, deux transistors CMOS de type P M7 et M8, une résistance R2, un condensateur C2 et une charge Z2. Le transistor M7 est monté en série avec le transistor M2 aux bornes de l'alimentation A1. Le transistor M8 et la charge Z2 sont placés en série aux bornes de l'alimentation A1. Le transistor M8 est monté en diode. La résistance R2 relie les grilles des transistors M7 et M8 de telle sorte que les transistors M7 et M8 constituent un miroir de courant statique. Le courant statique qui parcourt le transistor M7 recopie le courant statique qui parcourt le transistor M8. Le condensateur C2 relie les grilles des transistors M7 et M3 de telle sorte que les transistors M7 et M3 constituent un miroir de courant dynamique. Le courant dynamique qui parcourt le transistor M7 recopie le courant dynamique qui parcourt le transistor M3. Le transistor M7 étant monté en série avec le transistor M2, les mêmes courants statique et dynamique traversent les transistors M7 et M2. Plus le courant d'entrée i3 croît, plus le courant 12 traversant les transistors M7 et M2 croît, plus la réactivité du préamplificateur augmente et plus le courant i3 augmente.

De façon générale, un préamplificateur selon la présente invention comprend des moyens de détection d'une impulsion de courant en entrée du préamplificateur et des moyens de rétroaction pour augmenter le courant de polarisation d'au moins un des transistors M2, M4 de l'étage cascode du préamplificateur.

Dans les exemples de circuits décrits précédemment, les moyens de détection sont réalisés par le transistor M3 monté en diode. Les transistors M5, M6, le condensateur C1 et la résistance R1 constituent des moyens de rétroaction pour augmenter le courant de polarisation du transistor M4. Le condensateur C2 et la résistance R2 constituent des moyens de rétroaction pour augmenter le courant de polarisation du transistor M2.

Selon un perfectionnement de l'invention, le courant i3 délivré par le préamplificateur de courant est converti en tension de manière dynamique. Cette conversion permet, par rapport à des comparateurs selon l'art antérieur à base d'inverseur, de réduire encore plus la consommation statique.

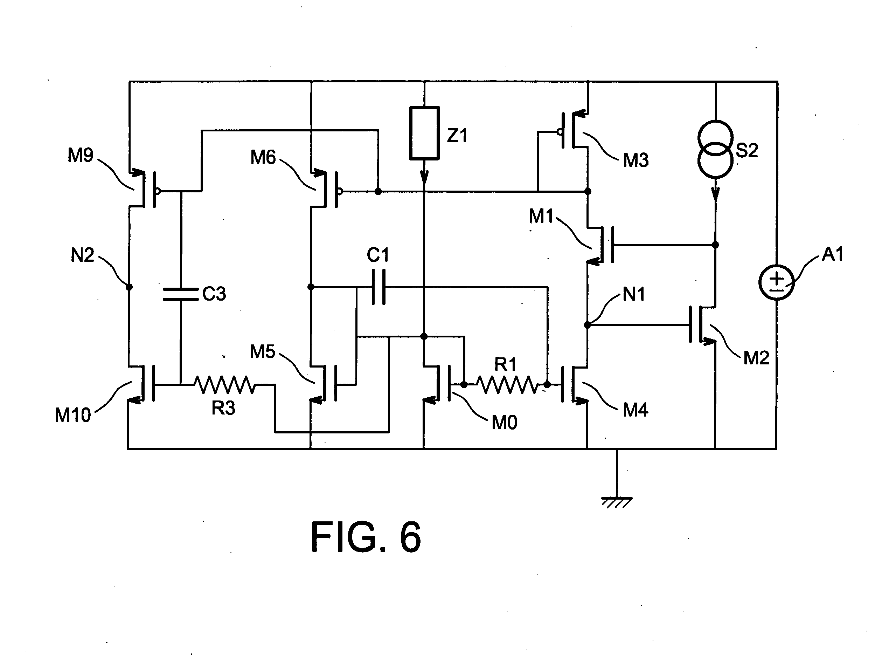

A titre d'exemple non limitatif, la figure 6 représente un préamplificateur de courant selon l'invention tel que celui représenté en figure 4 auquel est associé un convertisseur courant/tension apte à réduire la consommation statique. En plus des éléments représentés sur la figure 4, le circuit de la figure 6 comprend un transistor CMOS de type P M9, un transistor CMOS de type N M10, une résistance R3 et un condensateur C3. Les transistors M9 et M10 sont montés en série aux bornes de l'alimentation A1, le drain du transistor M9 étant relié au drain du transistor M10. Le condensateur C3 relie directement les grilles des transistors M9 et M10. La grille du transistor M9 est reliée directement à la grille du transistor M6 et la grille du transistor M10 est reliée à la grille du transistor M0 par l'intermédiaire de la résistance R3. La tension de sortie du convertisseur courant/tension est prise sur le noeud N2 qui relie les deux drains des transistors M9 et M10. De par la liaison qui existe entre eux (liaison directe des grilles), les transistors M3 et M9 constituent un miroir de courant tel que les courants statique et dynamique qui parcourent le transistor M9 recopient les courants statique et dynamique qui parcourent le transistor M3. Par ailleurs, de par la liaison qui existe entre eux (résistance R3 entre les grilles des deux transistors), les transistors M0 et M10 constituent un miroir de courant statique tel que le courant statique qui parcourt le transistor M10 recopie le courant statique qui parcourt le transistor M0. Enfin, de par la liaison qui existe entre eux (condensateur C3 entre les grilles des deux transistors), les transistors M3 et M10 constituent un miroir de courant dynamique « inverse ».

Du point de vue du courant statique, il s'en suit que les transistors M9 et M10 sont parcourus par le même courant statique. Le noeud N2 qui est le drain commun de ces transistors est en conséquence un noeud flottant positionné par exemple à mi-alimentation quand aucun courant dynamique ne parcourt les transistors M9 et M10.

Du point de vue du courant dynamique, il s'en suit que les transistors M9 et M10 sont parcourus chacun par un courant proportionnel au courant i3, les variations du courant dynamique qui parcourt le transistor M9 ayant toutefois un signe opposé aux variations du courant dynamique qui parcourt le transistor M10, de telle sorte que :

- (a) si le courant i3 croît, alors le courant total qui parcourt le transistor M9 croît et le courant total qui parcourt le transistor M10 décroît, et

- (b) si le courant i3 décroît, alors le courant total qui parcourt le transistor M9 décroît et le courant total qui parcourt le transistor M10 croît.

Dans le cas (a), la tension VN2 sur le noeud N2 croît et dans le cas (b), la tension VN2 sur le noeud N2 décroît.

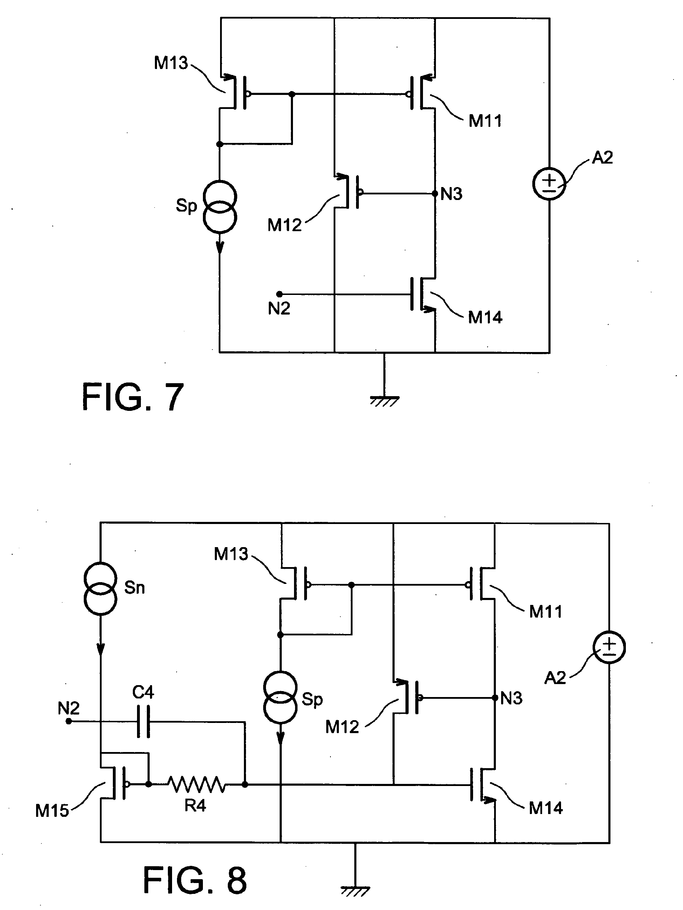

Les figures 7 et 8 représentent deux exemples de comparateur de tension utilisés dans le cadre de l'invention.

Le comparateur de tension représenté en figure 9 comprend trois transistors CMOS de type P M11, M12, M13, un transistor CMOS de type N M14, un générateur de courant Sp délivrant un courant Ip et une alimentation A2 correspondant éventuellement à l'alimentation A1. Le transistor M13, monté en diode, et le générateur de courant Sp sont en série aux bornes de l'alimentation A2. Les transistors M11 et M14 sont montés en série aux bornes de l'alimentation A2. Le transistor M12 a sa source reliée aux sources des transistors M11 et M13, son drain relié au noeud N2 de sortie du convertisseur courant/tension et sa grille reliée au drain commun des transistors M11 et M14, lequel constitue le noeud N3 de sortie du comparateur.

Le signal qui entre par le noeud N2 commande le transistor M14 monté en source commune qui est polarisé par le courant qui parcourt le transistor M11. Lorsque la tension au noeud N2 est fixe, en statique, la tension au noeud N3 est proche de celle de l'alimentation A2, de sorte que le transistor M12 est non conducteur. Le transistor M12 introduit un effet d'avalanche de telle sorte que son gain dynamique s'additionne au gain du transistor M14. Dès qu'un signal apparaît sur le noeud N2, la tension sur le noeud N3 « bascule » pour devenir sensiblement nulle.

Avec ce circuit, il existe cependant un risque de basculement du comparateur, sans présence d'un signal sur le noeud N2. Cela dépend en fait de la dimension absolue des transistors M9 et M10 du convertisseur courant/tension par rapport à celle du transistor M14. Le basculement peut notamment se produire en présence de bruit sur le noeud N2. Pour éviter l'imprécision de la tension VN2 du noeud N2 avant l'arrivée de tout signal, dû à une détection d'un courant d'appel i3, un circuit tel que celui représenté en figure 8 est avantageusement envisagé.

En plus des éléments représentés en figure 7, le circuit représenté en figure 8 comprend un transistor CMOS de type N M15 monté en diode, un générateur de courant supplémentaire Sn délivrant un courant I, une résistance R4 et un condensateur C4. Le générateur de courant supplémentaire Sn et le transistor M15 sont montés en série aux bornes de l'alimentation A2. La résistance R4 est placée entre les grilles des transistors M15 et M14 et le condensateur C4 a une première armature reliée à la grille du transistor M14 et une deuxième armature reliée au noeud N2.

En régime statique, les transistors M13 et M11 constituent un miroir de courant de telle sorte que le courant statique qui parcourt le transistor M11 recopie le courant statique qui parcourt le transistor M13. Également, les transistors M15 et M14 constituent un miroir de courant de telle sorte que le courant statique qui parcourt le transistor M14 recopie le courant statique qui parcourt le transistor M15. Les générateurs de courant Sp et Sn sont réglés de telle sorte que le courant Ip soit supérieur au courant In, le noeud N3 étant alors porté à la tension de l'alimentation A2.

En régime dynamique, lorsqu'une impulsion de tension se crée sur le noeud N2, le courant qui parcourt le transistor M14 s'accroît dans une forte proportion car la tension sur le noeud N2 croît et déséquilibre le miroir de courant (M15, M14). En conséquence, la tension sur le noeud N3 passe rapidement de la tension d'alimentation à la masse.

Dans l'exemple de comparateur de tension représenté en figure 8, on notera que le miroir de courant constitué par les transistors M11, M13 n'est pas indispensable. Un autre type de source de courant pourrait être placé en série avec le transistor M14 aux bornes de l'alimentation A2.

Par ailleurs, dans les exemples de comparateurs représentés en figures 7 et 8, les générateurs de courant Sp et Sn peuvent être constitués d'une simple charge de type résistive. Comme cela est connu de l'homme de l'art, le courant traversant le transistor M13 ou M15 est alors fonction de la géométrie du transistor considéré et de la valeur de la charge reliée à ce dernier. Inversement, les générateurs de courant S1 et S2 des dispositifs représentés en figures 3 à 6 pourraient être constitués de plusieurs miroirs de courant en série, les charges Z1 et Z2 étant alors remplacés par un ou plusieurs autres miroirs de courant.

De façon générale, les résistances de filtrage R1, R2, R3 et R4 mentionnée ci-dessus ont des valeurs élevées. Afin de limiter l'encombrement du circuit elles sont réalisées préférentiellement par des transistors MOS bloqués. En effet, les transistors MOS bloqués présentent une très forte impédance allant de quelques méga-ohms à quelques giga-ohms.

Le comparateur de courant de l'invention présente l'avantage d'avoir une très basse consommation et d'utiliser avantageusement le signal utile lui-même pour indexer la consommation dynamique du circuit et pour réaliser la comparaison avec une grande rapidité.

Par ailleurs, les différents circuits décrits précédemment pourraient être réalisés en logique complémentaire, les transistors PMOS étant remplacés par des transistors NMOS et inversement. Dans ce cas, la photodiode serait reliée à une tension d'alimentation, et non à la masse, et le noeud d'entrée N1 du préamplificateur recevrait un courant i3 lors de la réception d'un photon par la photodiode.

De plus, les circuits décrits précédemment pourraient être réalisés avec d'autres types de transistors que des transistors MOS, par exemple des transistors bipolaires.

Dans la présente demande, on entend par borne de commande d'un transistor, la borne permettant de décider de l'état conducteur ou non conducteur du transistor. Dans le cas d'un transistor MOS, la borne de commande est la grille du transistor. Dans le cas d'un transistor bipolaire la borne de commande est la base.

En outre, la présente invention peut être utilisée pour détecter un courant variable, de type impulsionnel, pouvant être demandé ou fourni par d'autres photodétecteurs qu'une photodiode. On entend par courant variable de type impulsionnel, tout courant présentant des variations haute fréquence.

De plus, les exemples de circuits décrits précédemment peuvent être alimentés par une unique alimentation ou par différentes alimentations.

## Revendications

1. Préamplificateur de courant (11) ayant une entrée (N1) apte à recevoir ou fournir un courant d'entrée (i3) présentant au moins une impulsion, le préamplificateur comprenant un étage cascode régulé comprenant un transistor d'entrée (M1) et un premier générateur de courant (S1) en série aux bornes d'une alimentation (A1), ainsi qu'un transistor de sortie (M2) et un second générateur de courant (S2) en série aux bornes de ladite alimentation, le premier noeud intermédiaire entre le premier générateur de courant et le transistor d'entrée constituant ladite entrée et étant relié à la borne de commande du transistor de sortie, le second noeud intermédiaire entre le second générateur de courant et le transistor de sortie étant relié à la borne de commande du transistor d'entrée, **caractérisé en ce qu'**il comprend :

   - des moyens de détection (M5, M6) aptes à détecter une impulsion du courant d'entrée (i3),
   - des premiers moyens de rétroaction (M3, M6, M4, M5, R1, C1) aptes à augmenter le courant (I1) délivré par le premier générateur de courant (S1) pendant toute la durée de détection de l'impulsion du courant d'entrée, et/ou
   - des second moyens de rétroaction (M3, M7, M8, R2, C2) aptes à augmenter le courant (I2) délivré par le second générateur de courant (S2) pendant toute la durée de détection d'une impulsion du courant d'entrée.

2. Préamplificateur de courant selon la revendication 1, dans lequel les moyens de détection aptes à détecter une impulsion du courant d'entrée (i3), comprennent un transistor de détection (M3) monté en diode et placé entre ledit transistor d'entrée et une borne de ladite alimentation (A1).

3. Préamplificateur de courant selon la revendication 1 ou 2, dans lequel le premier générateur de courant (S1) comprend des premier et deuxième transistors (M4, M0) montés en miroir de courant, le premier transistor étant placé entre l'entrée (N1) du préamplificateur et une borne de ladite alimentation (A1), le deuxième transistor (M0) étant monté en diode et étant traversé par un courant de polarisation prédéfini.

**4.** Préamplificateur de courant selon les revendications 2 et 3 dans lequel les premiers moyens de rétroaction comprennent :

- un troisième transistor (M6) relié au transistor de détection (M3) à la forme d'un miroir de courant, la borne de commande du troisième transistor étant reliée à la borne de commande du transistor de détection,
- un quatrième transistor (M5) monté en diode placé en série avec le troisième transistor aux bornes de ladite alimentation (A1),
- un premier condensateur (C1) placé entre les bornes de commande des premier et quatrième transistors (M4, M5), et
- une première résistance (R1) placée entre les bornes de commande des premier et deuxième transistors (M4, M0).

**5.** Préamplificateur de courant selon l'une des revendications précédentes, dans lequel le second générateur de courant (S2) comprend des cinquième et sixième transistors (M7, M8) montés en miroir de courant, le cinquième transistor (M7) étant placé entre ledit second noeud intermédiaire et une borne de ladite alimentation (A1), le sixième transistor étant monté en diode et étant traversé par un courant de polarisation prédéfini.

**6.** Préamplificateur de courant selon la revendication 5, dans sa dépendance de la revendication 2, dans lequel les seconds moyens de rétroaction comprennent :

- un deuxième condensateur (C2) placé entre les bornes de commande du transistor de détection (M3) et du cinquième transistor (M7), et
- une deuxième résistance (R2) placée entre les bornes de commande des cinquième et sixième transistors (M7, M8).

**7.** Comparateur de courant comprenant un préamplificateur de courant (11) et un convertisseur courant/tension (12) en série avec le préamplificateur de courant, **caractérisé en ce que** le préamplificateur de courant est un préamplificateur selon l'une quelconque des revendications 1 à 6.

**8.** Comparateur de courant selon la revendications 7, dans lequel le préamplificateur dépend de la revendication 3 lorsque la revendication 3 dépend de la revendication 2 et dans lequel le convertisseur courant/tension comprend des premier (M9) et second (M10) transistors supplémentaires de type différents montés en série aux bornes de ladite alimentation, les transistors supplémentaires étant reliés en un noeud de sortie (N2) du convertisseur courant/tension, un condensateur (C3) reliant les bornes de commande des transistors supplémentaires, les bornes de commande du transistor de détection (M3) et du premier transistor supplémentaire (M9) étant reliées l'une à l'autre, une résistance (R3) étant placée entre les bornes de commande dudit deuxième transistor (MO) et du second transistor supplémentaire (M10).

**9.** Comparateur de courant selon l'une quelconque des revendications 7 ou 8 qui comprend un comparateur de tension en série avec le convertisseur tension/courant.

**10.** Comparateur de courant selon la revendication 9, dans lequel le comparateur de tension comprend :

- un premier transistor (M14) d'un premier type en série avec une première source de courant (Sp, M13, M11) aux bornes d'une alimentation (A2), le noeud intermédiaire entre le premier transistor et la première source de courant constituant la sortie (N3) du comparateur de tension,
- un deuxième transistor (M12) d'un second type placé entre une borne de ladite alimentation et la borne de commande du premier transistor (M14), la borne de commande du deuxième transistor étant reliée à ladite sortie du comparateur de tension,
- un troisième transistor (M15) du premier type monté en diode, le troisième transistor étant en série avec une source de courant aux bornes de ladite alimentation,
- une résistance (R4) placée entre les bornes de commande des premier et troisième transistors (M14, M15), et
- un condensateur (C4) placé entre la borne de commande du premier transistor (M14) et l'entrée du comparateur de tension, et

dans lequel l'entrée du comparateur de tension est reliée au noeud de sortie (N2) du convertisseur courant/tension.

11. Circuit d'intégration photonique comprenant un comparateur de courant, **caractérisé en ce que** le comparateur de courant est un comparateur selon l'une quelconque des revendications 7 à 10.

**Claims**

1. Current pre-amplifier (11) with an input (N1) capable of receiving or supplying an input current (13) with at least one pulse, wherein the pre-amplifier comprises a regulated cascode stage comprising an input transistor (M1) and a first current generator (S1) in series at the terminals of a power supply (A1), as well as an output transistor (M2) and a second current generator (S2) in series at the terminals of said power supply, wherein the first intermediate node between the first current generator and the input transistor form said input and are connected to the command terminal of the output transistor, wherein the second intermediate node between the second current generator and the output transistor is connected to the command terminal of the input transistor, wherein said current pre-amplifier comprises:

   - detection means (M5, M6) capable of detecting an input current pulse (i3),
   - first feedback means (M3, M6, M4, M5, R1 C1) capable of increasing the current (I1) supplied by the first current generator (S1) during the entire detection of the input current pulse, and/or
   - second feedback means (M3, M7, M8, R2, C2) capable of increasing the current (12) supplied by the second current generator (S2) during the entire detection of an input current pulse.

2. Current pre-amplifier according to claim 1, wherein the detection means capable of detecting an input current pulse (i3) comprise a diode connected detection transistor (M3) placed between said input transistor and a terminal of said power supply (A1).

3. Current pre-amplifier according to claim 1 or 2, wherein the first current generator (S1) comprises first and second current mirror mounted transistors (M4, M0), wherein the first transistor is placed between the input (N1) of the pre-amplifier and a terminal of said power supply (A1), wherein the second transistor (M0) is diode connected and has a pre-defined polarisation current passing through it.

4. Current pre-amplifier according to claims 2 and 3, wherein the first feedback means comprise:

   - a third transistor (M6) connected to the detection transistor (M3) in the form of a current mirror, wherein the command terminal of the third transistor is connected to the command terminal of the detection transistor,
   - a fourth diode connected transistor (M5) placed in series with the third transistor at the terminals of said power supply (A1),
   - a first capacitor (C1) placed between the command terminals of the first and fourth transistors (M4, M5), and
   - a first resistor (R1) placed between the command terminals of the first and second transistors (M4, M0).

5. Current pre-amplifier according to any of the preceding claims, wherein the second current generator (S2) comprises fifth and sixth current mirror mounted transistors (M7, M8), wherein the fifth transistor (M7) is placed between said second intermediate node and a terminal of said power supply (A1), wherein the sixth transistor is diode connected and has a pre-defined polarisation current passing through it.

6. Current pre-amplifier according to claim 5 dependent on claim 2, wherein the second feedback means comprise:

   - a second capacitor (C2) placed between the command terminals of the detection transistor (M3) and the fifth transistor (M7), and
   - a second resistor (R2) placed between the command terminals of the fifth and sixth transistors (M7, M8).

7. Current comparator featuring a current pre-amplifier (11) and a current/voltage converter (12) in series with the current pre-amplifier, wherein the current pre-amplifier is a pre-amplifier according to any of claims 1 to 6.

8. Current comparator according to claim 7, wherein the pre-amplifier is in accordance with claims 2 and 3 and in which the current/voltage converter comprises first (M9) and second (M10) additional transistors of different types mounted in series at the terminals of said power supply, wherein the additional transistors are connected to an output node (N2) of the current/voltage converter, wherein a capacitor (C3) connects the command terminals of the additional transistors, wherein the commande terminals of the detection transistor (M3) and the first additional transistor (M9) are connected to one another, wherein one resistor (R3) is placed between the command terminals of said second transistor (MO) and the second additional transistor (M10).

9. Current comparator according to claim 7, wherein a voltage comparator is in series with the converter voltage/current.

10. Current comparator according to claim 9, wherein the voltage comparator comprises:

- a first transistor (M14) of a first type in series with a first current source (Sp, M13, M11) at the terminals of a power supply (A2), wherein the intermediate node between the first transistor and the first current source form the output (N3) of the voltage comparator,
- a second transistor (M12) of a second type placed between a terminal of said power supply and the command terminal of the first transistor (M14), wherein the command terminal of the second transistor is connected to said output of the voltage comparator,
- a third diode connected transistor (M15) of the first type, wherein the third transistor is in series with a current source at the terminals of said power supply,
- a resistor (R4) placed between the command terminals of the first and third transistors (M14, M15), and
- a capacitor (C4) placed between the command terminal of the first transistor (M14) and the input of the voltage comparator,

in which the input of the voltage comparator is connected to the output node (N2) of the current/voltage converter.

11. Photonic integration circuit comprising a current comparator, wherein the current comparator is a comparator according to any of claims 7 to 10.

## Patentansprüche

1. Stromvorverstärker (11) mit einem Eingang (N1), fähig einen Eingangsstrom (i3) mit wenigstens einem Impuls zu empfangen oder zu liefern, wobei der Vorverstärker eine regulierte Kaskodestufe mit einem Eingangstransistor (M1) und einem ersten Stromgenerator (S1) in Serie mit den Anschlüssen einer Versorgung (A1) sowie einen Ausgangstransistor (M2) und einen zweiten Stromgenerator (S2) in Serie mit den Anschlüsse der genannten Versorgung umfasst, wobei der erste Zwischenknoten, zwischen dem ersten Stromgenerator und dem Eingangstransistor, den genannten Eingang bildet und mit dem Steueranschluss des Ausgangstransistors verbunden ist, und der zweite Zwischenknoten, zwischen dem zweiten Stromgenerator und dem Ausgangstransistor, mit dem Steueranschluss des Eingangstransistors verbunden ist,
**dadurch gekennzeichnet, dass** er umfasst:

- Detektionseinrichtungen (M5, M6), fähig einen Eingangsstromimpuls (i3) zu detektieren,
- erste Rückkopplungseinrichtungen (M3, M6, M4, M5, R1, C1), fähig den durch den ersten Stromgenerator (S1) gelieferten Strom (I1) während der gesamten Detektionsdauer des Eingangsstromimpulses zu erhöhen, und/oder
- zweite Rückkopplungseinrichtungen (M3, M7, M8, R2, C2), fähig den durch den zweiten Stromgenerator (S2) gelieferten Strom (I2) während der gesamten Detektionsdauer eines Eingangsstromimpulses zu erhöhen.

2. Stromvorverstärker nach Anspruch 1, bei dem die zur Detektion eines Impulses eines Eingangsstroms (i3) fähigen Detektionseinrichtungen einen als Diode verschalteten und zwischen dem genannten Eingangstransistor und einem Anschluss der Versorgung (A1 geschalteten Detektionstransistor (M3) umfassen.

3. Stromvorverstärker nach einem der Ansprüche 1 oder 2, bei dem der erste Stromgenerator (S1) einen ersten und zweiten Transistor (M4, M0), verschaltet als Stromspiegelschaltung, umfasst, wobei der erste Transistor zwischen dem Eingang (N1) des Vorverstärkers und einem Anschluss der genannten Versorgung (A1) geschaltet ist und der zweite Transistor (M0) als Diode verschaltet ist und von einem vorher festgelegten Polarisationsstrom durchquert wird.

4. Stromvorverstärker nach den Ansprüchen 2 und 3, bei dem die ersten Rückkopplungseinrichtungen umfassen:

- einen dritten Transistor (M6), stromspiegelförmig mit dem Detektionstransistor (M3) verbunden, wobei der Steueranschluss des dritten Transistors mit dem Steueranschluss des Detektionstransistors verbunden ist,
- einen als Diode verschalteten Transistor (M5), der an den Anschlüssen der genannten Versorgung (A1) mit dem dritten Transistor in Serie geschaltet ist,
- einen zwischen den Steueranschlüssen des ersten und vierten Transistors (M4, M5) geschalteten Kondensator (C1), und
- einen zwischen den Steueranschlüssen des ersten und zweiten Transistors (M4, M0) geschalteten Widerstand (R1).

5.  Stromvorverstärker nach einem der vorangehenden Ansprüche, bei dem der zweite Stromverstärker (S2) einen fünften und sechsten Transistor (M7, M8) in Spiegelschaltung umfasst, wobei der fünfte Transistor (M7) zwischen dem genannten zweiten Zwischenknoten und einem Anschluss der genannten Versorgung (A1) geschaltet ist und der sechste Transistor als Diode verschaltet ist und von einem vorher festgelegten Polarisationsstrom durchquert wird.

6.  Stromvorverstärker nach Anspruch 5, in seiner Abhängigkeit von Anspruch 2, bei dem die zweiten Rückkopplungseinrichtungen umfassen:

    - einen zwischen den Steueranschlüssen des Detektionstransistors (M3) und des fünften Transistors (M7) geschalteten zweiten Kondensator (C2), und
    - einen zwischen den Steueranschlüssen des fünften und sechsten Transistors (M7, M8) geschalteten Widerstand (R2).

7.  Stromvergleicher mit einem Stromvorverstärker (11) und einem Strom-Spannungswandler (12), in Serie geschaltet mit dem Stromvorverstärker, **dadurch gekennzeichnet, dass** der Stromvorverstärker ein Vorverstärker nach einem der Ansprüche 1 bis 6 ist.

8.  Stromvergleicher nach Anspruch 7, bei dem der Vorverstärker von Anspruch 3 abhängig ist, wenn Anspruch 3 von Anspruch 2 abhängig ist, und bei dem der Strom-Spannungswandler Zusatztransistoren unterschiedlichen Typs umfasst, einen ersten (M9) und einen zweiten (M10), in Serie geschaltet mit den Anschlüssen der genannten Versorgung, wobei die Zusatztransistoren in einem Ausgangsknoten (N2) des Strom-Spannungswandlers verbunden sind und ein Kondensator (C3) die Steueranschlüsse der Zusatztransistoren verbindet und dabei die Steueranschlüsse des Detektionstransistors (M3) und des ersten Zusatztransistors (M9) miteinander verbunden sind und ein Widerstand R3 sich zwischen den Steueranschlüssen des genannten zweiten Transistors (M0) und dem zweiten Zusatztransistor (M10) befindet.

9.  Stromvergleicher nach einem der Anschlüsse 7 oder 8, der einen mit dem Strom-Spannungswandler in Serie geschalteten Spannungsvergleicher umfasst.

10. Stromvergleicher nach Anspruch 9, bei dem der Spannungsvergleicher umfasst:

    - einen ersten Transistor (M14) eines ersten Typs, in Serie geschaltet mit einer ersten Stromquelle (Sp, M13, M11), an den Anschlüssen einer Versorgung (A2), wobei der Zwischenknoten zwischen dem ersten Transistor und der ersten Stromquelle den Ausgang (N3) des Spannungsvergleichers bildet,
    - einen zweiten Transistor (M12) eines zweiten Typs, geschaltet zwischen einem Anschluss der genannten Versorgung und dem Steueranschluss des ersten Transistors (M14), wobei der Steueranschluss des zweiten Transistors mit dem genannten Ausgang des Spannungsvergleichers verbunden ist,
    - einen dritten Transistor (M15) des ersten Typs, als Diode verschaltet, wobei der dritte Transistor in Serie geschaltet ist mit eine Stromquelle, an den Anschlüssen der genannten Versorgung,
    - einen Widerstand (R4), geschaltet zwischen den Steueranschlüssen des ersten und dritten Transistors (M 14, M15), und
    - einen Kondensator (C4), geschaltet zwischen dem Steueranschluss des ersten Transistors (M14) und dem Eingang des Spannungsvergleichers, und

    bei dem der Eingang des Spannungsvergleichers mit dem Ausgangsknoten (N2) des Strom-Spannungswandlers verbunden ist.

11. Photonische Integrationsschaltung mit einem Stromvergleicher, **dadurch gekennzeichnet, dass** der Stromvergleicher ein Vergleicher nach einem der Ansprüche 7 bis 10 ist.

FIG. 1

FIG. 2

FIG. 3

FIG. 4

FIG. 5

FIG. 6

EP 1 931 030 B1

M13

Sp

M12

N2

M11

N3

M14

A2

**FIG. 7**

Sn

M13

C4

N2

M15

R4

Sp

M12

M11

N3

A2

M14

**FIG. 8**

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **LU CHEN ; BINGXUE SHI ; CHUN LU.** A high speed/power ratio continuous-time CMOS current comparator. *IEEE,* 2000, 883-886
- **TRAFF H.** Novel approach to high speed CMOS current comparator. *Electron. Lett.,* 1992, vol. 28 (3), 310-312

- **TANG, ATK ; TOUMAZOU C.** High performance CMOS current comparator. *Electron. Lett,* 1994, vol. 30 (1), 5-6
- **B.M. MIN ; S. W. KIM.** High performance CMOS current comparator using resistive feedback network. *Electron. Lett,* 1998, vol. 34 (22), 2074-2076